# EUROPEAN PATENT SPECIFICATION

(11) **EP 4 199 117 B1**
(45) Date of publication and mention of the grant of the patent: **08.04.2026**
(21) Application number: 22712487.2
(22) Date of filing: 12.01.2022
(51) Int. Cl.: H10D 30/01, H10D 30/60, H10D 30/69

(54) **SEMICONDUCTOR DEVICE, AND PREPARATION METHOD THEREFOR AND USE THEREOF**
HALBLEITERBAUELEMENT UND HERSTELLUNGSVERFAHREN DAFÜR UND VERWENDUNG DAVON
DISPOSITIF À SEMI-CONDUCTEUR, SON PROCÉDÉ DE PRÉPARATION ET SON UTILISATION

(30) Priority: 18.10.2021 CN 202111208074
(43) Date of publication of application: 21.06.2023
(73) Proprietor: Changxin Memory Technologies, Inc., Hefei City, Anhui 230601 (CN)
(72) Inventor: LEE, Tzung-han, Hefei, Anhui 230601 (CN)
(74) Representative: Lavoix
(86) International application number: PCT/CN2022/071632
(87) International publication number: WO 2023/065549

(56) References cited:
- EP-A2- 1 953 827
- CN-A- 103 811 557
- CN-A- 104 425 262
- CN-A- 105 612 617
- CN-A- 106 549 054
- CN-A- 106 549 054
- US-A1- 2005 032 321
- US-A1- 2012 181 631
- US-A1- 2012 319 215
- US-A1- 2016 247 579

## Description

### TECHNICAL FIELD

The disclosure relates to the technical field of the semiconductor, in particular to a semiconductor device, a method for manufacturing same and application thereof.

### BACKGROUND

With continuous development of integrated circuit industry, silicon-based integrated circuit technology, which is driven by equal proportion reduction of metal oxide semiconductor (MOS) devices, has entered nanometer size. However, further reduction of transistor size also has an impact on transistor performance, such as the generation of Gate Induced Drain Leakage (GIDL) current, which affects device performance. US 2012/319215 A1 discloses a semiconductor device and a method for manufacturing a semiconductor device, as known in the prior art.

### SUMMARY

The subject matter of the present invention is defined in claims 1 and 6. In view of this, embodiments of the disclosure provide a semiconductor device, a method for manufacturing it and an application thereof.

According to a first aspect of the embodiment of the disclosure, a semiconductor device is provided. The semiconductor device includes a substrate; a semiconductor material layer located on the substrate and covering part of the substrate; a gate located on the semiconductor material layer and the substrate not covered by the semiconductor material layer; in which along an extension direction of the gate, a width of the semiconductor material layer is smaller than a width of the substrate, and a carrier mobility of a material of the semiconductor material layer is different from a carrier mobility of a material of the substrate.

In some embodiments, the material of the substrate includes a first element, and the material of the semiconductor material layer includes the first element and a second element different from the first element.

In some embodiments, the first element is silicon and the second element is germanium.

In some embodiments, a percentage content of the second element in the semiconductor material layer ranges from 20% to 40%.

In some embodiments, the semiconductor device includes three states, and in the case that a voltage applied to the semiconductor device is less than a first threshold, the semiconductor device is in an off state; in the case that the voltage is greater than the first threshold and less than a second threshold, the semiconductor device is in a semi-conducting state; in the case that the voltage is greater than the second threshold, the semiconductor device is in a full-conducting state.

In some embodiments, the semiconductor device further includes: a source and a drain, which are respectively located on both sides of the gate and penetrate through the semiconductor material layer and extend into the substrate.

According to a second aspect of the embodiment of the disclosure, a method for manufacturing a semiconductor device is provided. The method for manufacturing a semiconductor device includes: providing a substrate; forming a semiconductor material layer on the substrate, in which the semiconductor material layer covers a part of the substrate; forming a gate on the semiconductor material layer and the substrate not covered by the semiconductor material layer; in which, along an extension direction of the gate, a width of the semiconductor material layer is smaller than a width of the substrate, and a carrier mobility of a material of the semiconductor material layer is different from a carrier mobility of a material of the substrate.

In some embodiments, the material of the substrate includes a first element, and the material of the semiconductor material layer includes the first element and a second element different from the first element.

In some embodiments, the first element is silicon and the second element is germanium.

In some embodiments, a percentage content of the second element in the semiconductor material layer ranges from 20% to 40%.

In some embodiments, the semiconductor material layer is formed by an in-situ doping epitaxial process, in which growth rates of the semiconductor material layer in a middle area and an edge area of the substrate are adjusted by controlling a flow rate of a growth gas, so that the semiconductor material layer covers a part of the substrate.

In some embodiments, a photoresist layer is formed on a mask layer covering the substrate. The photoresist layer is exposed and developed to transfer a preset pattern of the semiconductor material layer in a photomask to the photoresist layer. A portion of the mask layer corresponding to the preset pattern of the semiconductor material layer is removed to expose part of the substrate. The semiconductor material layer is formed on the exposed substrate.

In some embodiments, the method further includes: Ion doping is carried out on the semiconductor material layer on both sides of the gate and the substrate under the semiconductor material layer to form a source and a drain penetrating through the semiconductor material layer and extending into the substrate.

According to a third aspect of the embodiment of the disclosure, an application of a semiconductor device in a circuit is provided, the circuit includes: a main word line, a sub word line, a word line driving circuit and a voltage control module, in which the voltage control module includes the semiconductor device as described in anyone of the above embodiments.

The semiconductor device includes a source terminal, a drain terminal and a gate terminal; the source terminal is connected to a high-level signal, the drain terminal is connected to a main word line, and the gate terminal is connected to a standby signal.

The word line driving circuit is connected between the main word line and the sub word line.

The voltage control module is configured to reduce a voltage output to the word line driving circuit in the case that a standby state occurs.

In some embodiments, the word line driving circuit includes a first PMOS transistor, a first NMOS transistor and a second NMOS transistor; the gates of the first PMOS transistor and the first NMOS transistor are connected and are connected to the main word line; the source of the first NMOS transistor and the source of the second NMOS transistor are connected and are grounded; the drain of the first PMOS transistor, the drain of the first NMOS transistor and the drain of the second NMOS transistor are connected and are connected to the sub word line.

According to a fourth aspect of the embodiment of the disclosure, a method for driving a circuit is provided, the method for driving a circuit is applied to the circuit described in anyone of the embodiments of the third aspect of the disclosure; the method includes: controlling the semiconductor device to be in the off state in the case that the standby state does not occur; and controlling the semiconductor device to be in the semi-conducting state in the case that the standby state occurs, so as to increase an equivalent resistance of the semiconductor device and reduce a voltage output to the word line driving circuit.

In the embodiments of the disclosure, by forming a semiconductor material layer with a width smaller than the width of the substrate along the extension direction of the gate, and according to a difference between the carrier mobility of the semiconductor material layer and the carrier mobility of the substrate, a control device with at least three states is provided, which at least includes three states of off, semi-conducting and full-conducting. In practical circuit application, it can switch various working states according to the voltage and reduce GIDL current.

### BRIEF DESCRIPTION OF THE DRAWINGS

FIG. 1 is a top view of a semiconductor device provided by an embodiment of the disclosure;
FIG. 2 is a sectional view taken along the direction of the dotted line A-A' in FIG. 1;
FIG. 3 is a sectional view taken along the direction of the dotted line B-B' in FIG. 1;
FIG. 4 is a graph showing the relationship between gate voltage and drain current;
FIG. 5 is a schematic flow chart of a method for manufacturing a semiconductor device provided by an embodiment of the disclosure;
Figs. 6A to 6G are schematic structural diagrams of a semiconductor device provided by an embodiment of the disclosure in the manufacturing process; and
FIG. 7 is a circuit diagram of a circuit provided by an embodiment of the disclosure.

### Description of reference numbers:

10- substrate;
20- semiconductor material layer;
30- gate;
41- source;
42- drain;
50- mask layer;
60- photoresist layer;
71- word line driving circuit; 711- first PMOS transistor; 712- first NMOS transistor; 713- second NMOS transistor;
72- voltage control module; 71-semiconductor device.

### DETAILED DESCRIPTION

Exemplary embodiments of the disclosure will be described in more detail below with reference to the accompanying drawings. Although exemplary embodiments of the disclosure are shown in the drawings, it should be understood that the disclosure can be realized in various forms and should not be limited by the specific embodiments set forth herein. On the contrary, these embodiments are provided to enable a more thorough understanding of the disclosure and to fully convey the scope of the disclosure to those skilled in the art.

In the following description, numerous specific details are given in order to provide a more thorough understanding of the disclosure. However, it will be obvious to those skilled in the art that the disclosure can be practiced without one or more of these details. In other examples, in order to avoid confusion with this disclosure, some technical features known in the art are not described; that is, all the features of the actual embodiment are not described here, and well-known functions and structures are not described in detail.

In the drawings, the dimensions of layers, regions and elements and their relative dimensions may be exaggerated for clarity. The same reference numeral refers to that same element throughout.

It should be understood that when an element or layer is referred to as "on", "adjacent to", "connected to" or "coupled to" other elements or layers, it may be directly on, adjacent to, connected to or coupled to other elements or layers, or there may be intervening elements or layers. On the contrary, when an element is referred to as directly on, directly adjacent to, directly connected to or directly coupled to other elements or layers, there is no intervening element or layer. It should be understood that although the terms first, second and third can be used to describe various elements, components, regions, layers and/or parts, these elements, components, regions, layers and/or parts should not be limited by these terms. These terms are only used to distinguish one element, component, region, layer or part from another element, component, region, layer or part. Therefore, the first element, component, region, layer or part discussed below can be expressed as the second element, component, region, layer or part without departing from the teachings of the disclosure. When the second element, component, region, layer or part is discussed, it does not mean that the first element, component, region, layer or part necessarily exists in this disclosure.

Spatial terms such as under, below, the lower, beneath, on, above, etc. can be used here to describe the relationship between one element or feature shown in the figure and other elements or features. It should be understood that in addition to the orientations shown in the figures, the spatial relationship term is intended to include different orientations of devices in use and operation. For example, if the device in the drawing is flipped over, then the element or feature described as "under other elements" or "under them" or "below them" will be oriented to be "above" other elements or features. Therefore, the exemplary terms "under ... " and "below ..." may include both the up and down orientations. The device can be otherwise oriented (rotated by 90 degrees or other orientations) and the spatial descriptors used herein should be interpreted accordingly.

The terminology used here is only for the purpose of describing specific embodiments and is not a limitation of the disclosure. As used herein, singular forms of "a", "an" and "the" are also intended to include plural forms, unless the context clearly indicates otherwise. It should also be understood that the terms "include" and/or "comprise", when used in this specification, determine the presence of said features, integers, steps, operations, elements and/or components, but do not exclude the presence or addition of one or more other features, integers, steps, operations, elements, components and/or groups. As used herein, the term "and/or" includes anyone and all combinations of related listed items.

For a thorough understanding of the disclosure, detailed steps and detailed structures will be put forward in the following description to explain the technical scheme of the disclosure. The detailed description of the preferred embodiments of the disclosure is as follows, however, in addition to these detailed descriptions, the disclosure may have other embodiments.

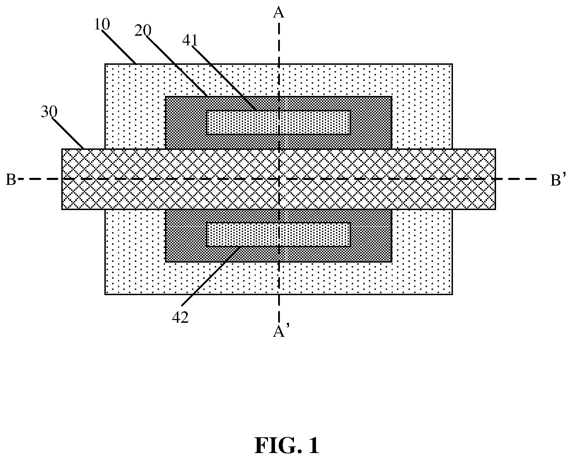

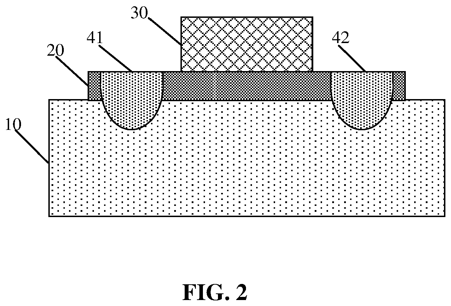

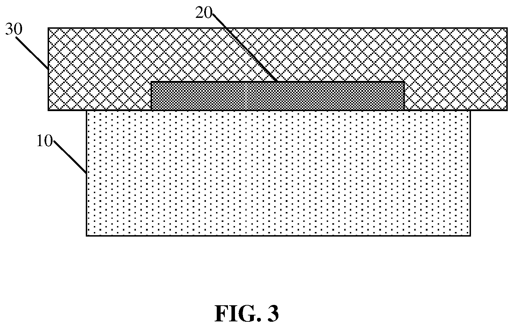

An embodiment of the disclosure provides a semiconductor device. FIG. 1 is a top view of a semiconductor device provided by an embodiment of the disclosure, FIG. 2 is a cross-sectional view along the dotted line A-A' in FIG. 1, and FIG. 3 is a cross-sectional view along the dotted line B-B' in FIG. 1.

Referring to FIGs. 1 to 3, the semiconductor device includes: a substrate 10; a semiconductor material layer 20 located on the substrate 10 and covering a part of the substrate 10; a gate 30 located on the semiconductor material layer 20 and the substrate 10 not covered by the semiconductor material layer 20; in which a width of the semiconductor material layer 20 is smaller than a width of the substrate 10 along an extending direction of the gate 30, and a carrier mobility of the material of the semiconductor material layer 20 and a carrier mobility of the material of the substrate 10 are different.

In the embodiment of the disclosure, by forming the semiconductor material layer with the width smaller than the width of the substrate along the extension direction of the gate, and according to the difference between the carrier mobility of the semiconductor material layer and the carrier mobility of the substrate, a control device with at least three states is provided, which at least includes three states of off, semi-conducting and full-conducting. In practical circuit application, it can switch various working states according to the voltage and reduce GIDL current.

The substrate 10 may be an elementary semiconductor material substrate (such as silicon (Si) substrate, germanium (Ge) substrate, etc.), a composite semiconductor material substrate (such as silicon germanium (SiGe) substrate, etc.), or a silicon-on-insulator (SOI) substrate, germanium-on-insulator (GeOI) substrate, etc. In the embodiment of the disclosure, the substrate 10 is a silicon substrate.

In an embodiment, the carrier mobility of the semiconductor material layer 20 is greater than the carrier mobility of the substrate 10 material, thus improving the carrier mobility of the channel region, optimizing the operation speed of the semiconductor device and improving the electrical performance of the semiconductor device.

The gate 30 may include an oxide layer, a first gate conductive layer, a second gate conductive layer and other structures (not shown in the figures) stacked in sequence.

In an embodiment, as shown in FIG. 1, the width of the semiconductor material layer 20 is smaller than the width of the substrate 10 along the direction perpendicular to the extension of the gate 30. In other embodiments, the width of the semiconductor material layer 20 may be equal to the width of the substrate 10 along a direction perpendicular to the extension of the gate 30.

In an embodiment, the material of the substrate 10 includes a first element, and the material of the semiconductor material layer 20 includes the first element and a second element different from the first element. In this way, because there is a difference between the materials of the substrate and the semiconductor material layer, the carrier mobility can be influenced, so that the threshold voltages of the channel regions respectively formed in the semiconductor material layer and the substrate are different.

In an embodiment, the first element is silicon and the second element is germanium. That is, the substrate 10 is a silicon substrate, and the semiconductor material layer 20 is a germanium silicon layer. There is a lattice difference between germanium and silicon, by which the carrier mobility may be affected and thus the threshold voltage of the channel region is adjusted. In other embodiments, the first element and the second element may also be selected from other elements that can affect the carrier mobility, such as but not limited to silicon, germanium, boron, tellurium, iodine, carbon, phosphorus, arsenic, sulfur and the like.

In other embodiments, the substrate 10 is a silicon substrate, and the semiconductor material layer 20 is a germanium silicon layer containing carbon.

In an embodiment, a percentage content of the second element in the semiconductor material layer 20 ranges from 20% to 40%. Therefore, in the range, the semiconductor material layer can better influence the carrier mobility and adjust the threshold voltage of the channel region, so that the formed third-stage control device can better reduce the GIDL current.

In an embodiment, the semiconductor material layer 20 includes a first semiconductor material layer and a second semiconductor material layer (not shown in the figures). The first semiconductor material layer and the second semiconductor material layer are arranged side by side, and both the first semiconductor material layer and the second semiconductor material layer extend along the direction from the source to the drain. The mobility of the material of the first semiconductor material layer, the mobility of the material of the second semiconductor material layer and the mobility of the material of the substrate are different. In this way, according to the difference in carrier mobility of the first semiconductor material layer, the second semiconductor material layer and the substrate, the semiconductor device can be formed into a device with more states.

In an embodiment, as shown in FIG. 3, the length of the gate 30 is longer than the length of the substrate 10 along the extending direction of the gate 30, that is, the gate 30 may be located on other structures, so the length of the gate 30 is longer than the length of the substrate 10. In this way, the control ability of the channel region can be improved, and the leakage problem of devices can be improved, meanwhile multiple device structures can share the same gate.

In an embodiment, the semiconductor device includes three states. When the voltage applied to the semiconductor device is less than a first threshold, the semiconductor device is in the off state. When the voltage is greater than the first threshold and less than a second threshold, the semiconductor device is in a semi-conducting state. When the voltage is greater than the second threshold, the semiconductor device is in a full-conducting state.

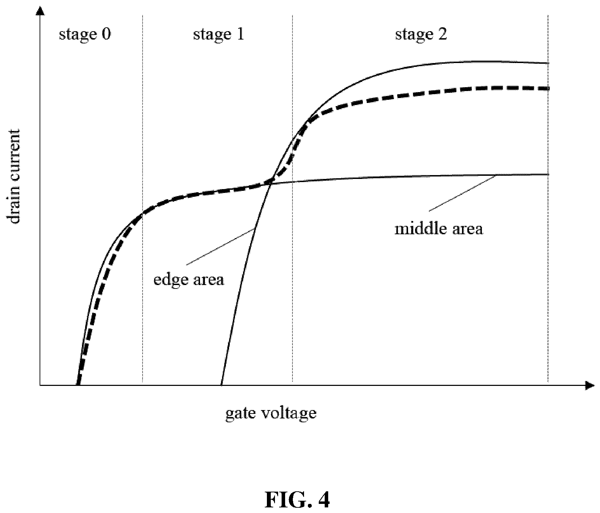

Specifically, as shown in FIG. 1, since the width of the semiconductor material layer 20 in the direction extending along the gate 30 is smaller than the width of the substrate 10, the channel region of the semiconductor device is divided into two parts, one part is the middle area covered by the semiconductor material layer 20, and the other part is the edge area not covered by the semiconductor material layer 20. Since the semiconductor material layer 20 only partially grows on the substrate 10, the threshold voltage of the channel region in the middle area covered by the semiconductor material layer 20 is low, and the middle area can be turned on in advance. When the voltage reaches the threshold voltage of the edge area, the channel in the edge area can be turned on. Finally the voltage versus current curve formed is shown in FIG. 4.

Referring to FIG. 4, in stage 0, the voltage of the semiconductor device is less than the first threshold, and neither the middle area nor the edge area reaches the on state, so the semiconductor device is in the off state; in stage 1, the voltage of the semiconductor device is greater than the first threshold and less than the second threshold, and the middle region reaches the on state, while the edge area is still in the off state, so the semiconductor device is in the semi-conducting state, and redundancy to the gate voltage is high, and the drain current does not change due to slight fluctuation of the gate voltage; in stage 2, the voltage of the semiconductor device is greater than the second threshold, and both the middle area and the edge area reach the on state, so the semiconductor device is in the full-conducting state and operates in the saturation region. The three states of the semiconductor device are shown by the dotted line in FIG. 4. Thus, the semiconductor device provided by an embodiment of the disclosure is a control device with three states.

**In** an embodiment, as shown in FIG. 2, the semiconductor device further includes a source 41 and a drain 42, which are located on both sides of the gate 30 and penetrate through the semiconductor material layer 20 and extend into the substrate 10.

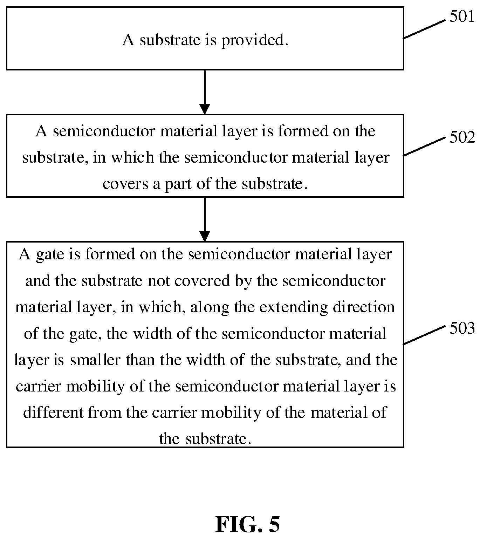

**In** an embodiment of the disclosure, a method for manufacturing a semiconductor device is also provided. For details, please refer to FIG. 5. As shown in the figure, the method includes the following operations.

**In** the operation 501, a substrate is provided.

**In** the operation 502, a semiconductor material layer is formed on the substrate, in which the semiconductor material layer covers a part of the substrate.

In the operation 503, a gate is formed on the semiconductor material layer and the substrate not covered by the semiconductor material layer, in which, along the extending direction of the gate, the width of the semiconductor material layer is smaller than the width of the substrate, and the carrier mobility of the material of the semiconductor material layer is different from the carrier mobility of the material of the substrate.

Next, the method for manufacturing a semiconductor device provided by the embodiment of this disclosure is described in further detail in combination with the specific embodiment.

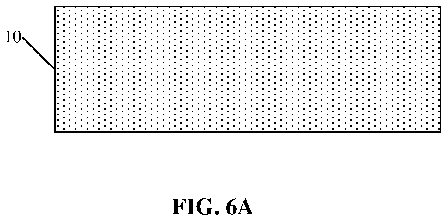

Figs. 6A to 6G are schematic structural diagrams of a semiconductor device provided by the embodiment of the disclosure in the manufacturing process.

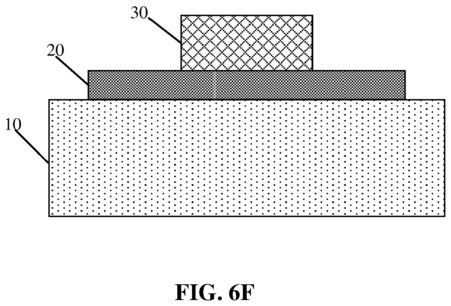

It should be noted that FIGs. 6A to 6E are sectional views along the dotted line B-B' in FIG. 1, and FIGs. 6F to 6G are sectional views along the dotted line A-A' in FIG. 1.

First, referring to FIG. 6A, the operation 501 is performed to provide a substrate 10. The substrate 10 may be an elementary semiconductor material substrate (such as silicon (Si) substrate, germanium (Ge) substrate, etc.), a composite semiconductor material substrate (such as silicon germanium (SiGe) substrate, etc.), or a silicon-on-insulator (SOI) substrate, germanium-on-insulator (GeOI) substrate, etc. In the embodiment of the disclosure, the substrate 10 is the silicon substrate.

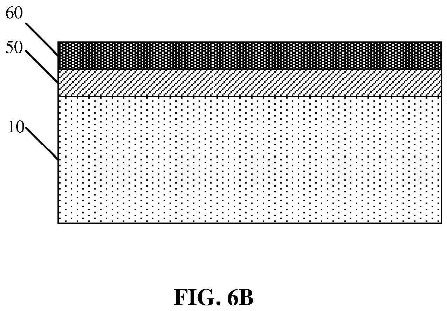

Next, referring to FIGs. 6B to 6D, the operation 502 is performed. A semiconductor material layer 20 is formed on the substrate 10, and the semiconductor material layer 20 covers a part of the substrate 10.

In practice, referring to FIG. 6B, a mask layer 50 may be formed on the substrate 10 firstly, and then a photoresist layer 60 may be formed on the mask layer 50 covering the substrate 10.

**In** an embodiment, the mask layer 50 may be a composite material layer of silicon dioxide and silicon nitride.

Then, the photoresist layer 60 is exposed and developed to transfer a preset pattern of the semiconductor material layer on a photomask (not shown in the figure) to the photoresist layer 60, forming a patterned photoresist layer.

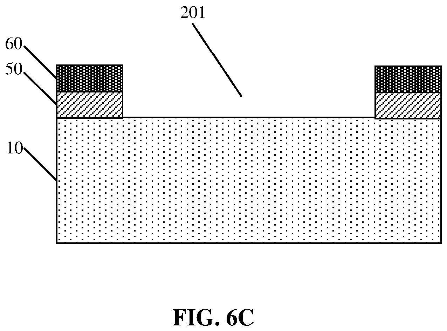

Referring to FIG. 6C, based on the patterned photoresist layer, the part of the mask layer 50 corresponding to the preset pattern of the semiconductor material layer is etched to expose a part of the substrate 10. In an embodiment, the mask layer and the photoresist layer located in the middle area of the substrate 10 are removed to expose the middle area of the substrate 10.

Optionally, the photoresist layer 60 is a positive photoresist or a negative photoresist. The positive photoresist may form soluble substances after illumination, while the negative photoresist forms insoluble substances after illumination.

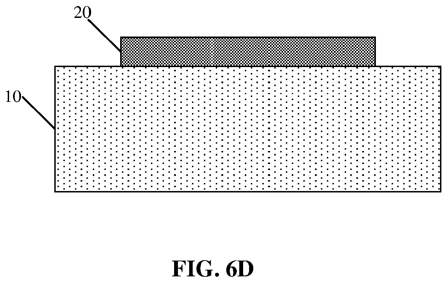

Referring to FIG. 6D, the semiconductor material layer 20 is formed on the exposed substrate 10. After forming the semiconductor material layer 20, the remaining photoresist layer 60 and mask layer 50 are removed.

In the embodiment of the disclosure, the photomask for forming the semiconductor material layer may be formed by modifying the photomask in the previous process, such as a PMOS mask, without adding a new photomask. In this way, the process can be reduced and the cost can be saved.

In the embodiment shown in FIGs. 6B to 6D, the semiconductor material layer 20 is formed by a method for forming the photoresist layer, and in other embodiments, the semiconductor material layer 20 may also be formed by an in-situ doping epitaxial process.

The semiconductor material layer 20 is formed by the in-situ doping epitaxial process, in which growth rates of the semiconductor material layer 20 in the middle area and the edge area of the substrate 10 are adjusted by controlling the flow rate of growth gas, so as to make the semiconductor material layer 20 cover a part of the substrate 10.

Particularly, the growth gas includes HCL, SiH₄ and GeH₄. Different percentage contents of germanium atoms can be obtained by adjusting the flow ratio of HCL, SiH₄ and GeH₄, and the germanium atoms are evenly distributed, the process step is simple, and the uniformity of the formed semiconductor material layer is good.

In an embodiment, the material of the substrate 10 includes a first element, and the material of the semiconductor material layer 20 includes the first element and a second element different from the first element. In this way, because there is a difference between the materials of the substrate 10 and the semiconductor material layer 20, the carrier mobility can be influenced, and then the threshold voltages of the channel regions in the semiconductor material layer 20 and the substrate 10 are different.

In an embodiment, the first element is silicon and the second element is germanium. That is, the substrate 10 is a silicon substrate, and the semiconductor material layer 20 is a germanium silicon layer. There is a lattice difference between germanium and silicon, by which the carrier mobility can be affected and thus the threshold voltage of the channel region is adjusted. In other embodiments, the first element and the second element may also be selected from other elements that can affect the carrier mobility, such as but not limited to silicon, germanium, boron, tellurium, iodine, carbon, phosphorus, arsenic, sulfur and the like.

In other embodiments, the substrate 10 is a silicon substrate, and the semiconductor material layer 20 is a germanium silicon layer containing carbon.

In an embodiment, a percentage content of the second element in the semiconductor material layer ranges from 20% to 40%. Therefore, in the range, the semiconductor material layer can better influence the carrier mobility and adjust the threshold voltage of the channel region, so that the formed control device with three states can better reduce the GIDL current.

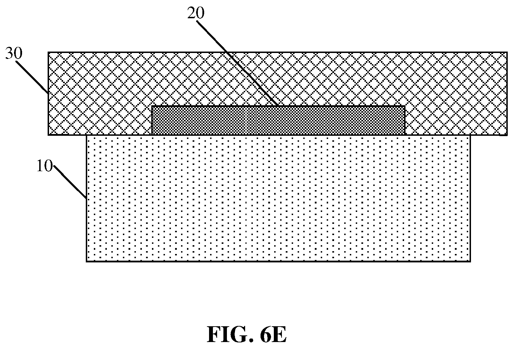

Next, refer to FIG. 6E and FIG. 6F. It should be noted that FIG. 6E is a sectional view along the dotted line B-B' in FIG. 1, and FIG. 6F is a sectional view along the dotted line A-A' in FIG. 1. The operation 503 is performed, a gate 30 is formed on the semiconductor material layer 20 and the substrate 10 not covered by the semiconductor material layer 20; in which the width of the semiconductor material layer 20 is smaller than the width of the substrate 10 along the extending direction of the gate 30, and the carrier mobility of the material of the semiconductor material layer 20 is different from that of the substrate 10.

**In** an embodiment, the carrier mobility of the semiconductor material layer 20 is greater than the carrier mobility of the material of the substrate 10, thus improving the carrier mobility of the channel region, optimizing the operation speed of the semiconductor device and improving the electrical performance of the semiconductor device.

**In** practice, the formation of the gate 30 specifically includes: firstly, a mask layer (not shown in the figures) can be formed on the semiconductor material layer 20 and the substrate 10 not covered by the semiconductor material layer 20, and then the mask layer is patterned, to bring out the gate trench pattern to be etched in the mask layer, and the mask layer may be patterned by photolithography technique. The mask layer may be a photoresist mask or a hard mask patterned based on a photolithography mask. When the mask layer is the photoresist mask, the mask layer is specifically patterned through the operations of exposure, development, removing of photoresist and the like. Then, the gate trench with a certain depth is etched according to the pattern of the gate trench to be etched. Then, the gate is formed **in** the gate trench, and the redundant mask layer is removed.

The gate 30 may include an oxide layer, a first gate conductive layer, a second gate conductive layer and other structures (not shown in the figures) stacked in sequence.

**In** an embodiment, the semiconductor device includes three states, and when a voltage applied to the semiconductor device is less than a first threshold, the semiconductor device is in an off state; when the voltage is greater than the first threshold and less than a second threshold, the semiconductor device is in a semi-conducting state; when the voltage is greater than the second threshold, the semiconductor device is in a fully full-conducting state.

Specifically, as shown in FIG. 1, since the width of the semiconductor material layer 20 in the direction extending along the gate 30 is smaller than the width of the substrate 10, the channel region of the semiconductor device is divided into two parts, one part is the middle area covered by the semiconductor material layer 20, and the other part is the edge area not covered by the semiconductor material layer 20. Since the semiconductor material layer 20 only grows on part of the substrate 10, the threshold voltage of the channel region in the middle region covered by the semiconductor material layer 20 is relatively low, and the middle area will be turned on in advance. When the voltage reaches the threshold voltage of the edge area, the channel in the edge area is turned on. Finally, the voltage versus current curve formed is shown in FIG. 4.

Referring to FIG. 4, in stage 0, the voltage of the semiconductor device is less than the first threshold, and neither the middle area nor the edge area reaches the on state, so the semiconductor device is in the off state; in stage 1, the voltage of the semiconductor device is greater than the first threshold and less than the second threshold, and the middle region reaches the on state, while the edge area is still in the off state, so the semiconductor device is in the semi-conducting state, and redundancy to the gate voltage is high, and the drain current does not change due to slight fluctuation of the gate voltage; in stage 2, the voltage of the semiconductor device is greater than the second threshold, and both the middle area and the edge area reach the on state, and thus the semiconductor device is in full-conducting state and operates in the saturation region. The three states of the semiconductor device are shown by the broken line in FIG. 4. Therefore, the semiconductor device provided by the embodiment of this disclosure is a control device with three states.

In an embodiment, as shown in FIG. 6E, the length of the gate 30 is greater than the length of the substrate 10 along the extending direction of the gate 30, that is, the gate 30 may be located on other structures, and thus the length of the gate 30 is greater than the length of the substrate 10. In this way, the control ability of the channel region can be improved, and the device leakage problem can be improved; meanwhile multiple device structures can share the same gate.

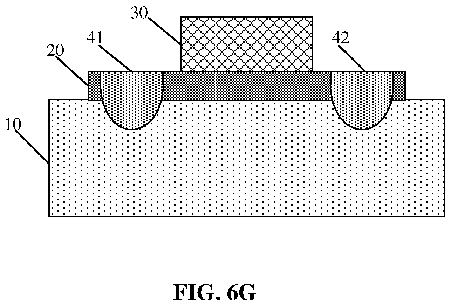

Next, referring to FIG. 6G, the semiconductor material layer 20 on both sides of the gate 30 and the substrate 10 under the semiconductor material layer 20 are ion doped to form the source 41 and the drain 42 penetrating through the semiconductor material layer 20 and extending into the substrate 10.

Specifically, in an embodiment, a lightly doped drain region implantation process (LDD), a source/drain region (S/D) ion implantation and an annealing process may be sequentially performed, so that the source 41 and the drain 42 are formed on both sides of the gate 30; the specific process parameters may be set according to actual process requirements, which is not limited in this disclosure.

In an embodiment, the semiconductor material layer 20 includes a first semiconductor material layer and a second semiconductor material layer (not shown in the figures). The first semiconductor material layer and the second semiconductor material layer are arranged side by side, and both the first semiconductor material layer and the second semiconductor material layer extend along the direction from the source to the drain. The mobility of the material of the first semiconductor material layer, the mobility of the material of the second semiconductor material layer and the mobility of the material of the substrate are different. In this way, according to the difference in carrier mobility of the first semiconductor material layer, the second semiconductor material layer and the substrate, the semiconductor device can be formed into a device with more states.

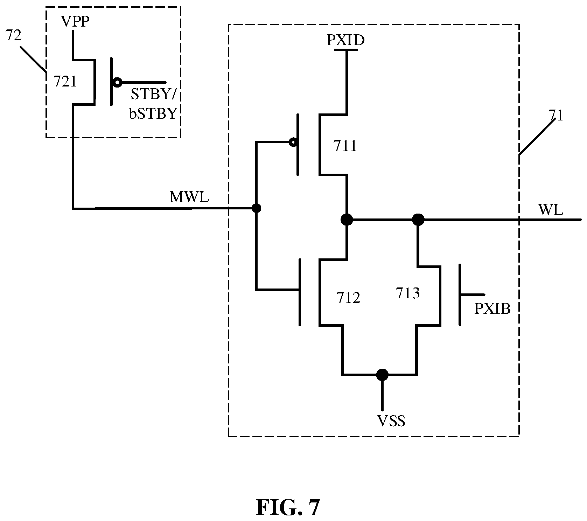

In an embodiment of the disclosure, a circuit is further provided, in which the above semiconductor device is applied. As shown in FIG. 7, the circuit includes: a main word line MWL, a sub word line WL, a word line driving circuit 71 and a voltage control module 72, and the voltage control module 72 includes the semiconductor device 721 as described in anyone of the above embodiments.

The semiconductor device 721 includes a source terminal, a drain terminal and a gate terminal. The source terminal is connected to the high level signal VPP, the drain terminal is connected to the main word line MWL, and the gate terminal is connected to the standby signal STBY.

The word line driving circuit 71 is connected between the main word line MWL and the sub word line WL.

The voltage control module 72 is configured to reduce the voltage output to the word line driving circuit 71 when the standby state occurs.

In the traditional circuit, the main word line MWL is at a high level, the sub word line WL is at a low level, and there is a voltage difference between the gate and the source or drain of the first PMOS transistor 711, which will cause the first PMOS transistor 711 to be affected by GIDL current. Therefore, in the embodiment of this disclosure, the voltage control module 72 is added to the main word line MWL, in this way, in the standby state, the semiconductor device can be controlled in the state of stage 1 as shown in FIG. 4, that is, the semi-conducting state, so that the equivalent resistance of the semiconductor device increases and then the voltage output to the word line driving circuit 71 is reduced, reducing the GIDL current.

The semiconductor device 721 is a PMOS transistor.

In an embodiment, the word line driving circuit 71 includes a first PMOS transistor 711, a first NMOS transistor 712 and a second NMOS transistor 713.The gates of the first PMOS transistor 711 the first NMOS transistor 712 are connected and are connected to the main word line MWL; the source of the first NMOS transistor 712 and the source of the second NMOS transistor 713 are connected and are grounded. The drain of the first PMOS transistor 711, the drain of the first NMOS transistor 712 and the drain of the second NMOS transistor 713 are connected and are connected to the sub-word line WL.

In an embodiment, the first PMOS transistor 711 and the first NMOS transistor 712 are formed to be an inverting circuit. The inverting circuit has an input terminal connected to the main word line MWL and an output terminal connected to the sub word line WL. The source of the first PMOS transistor 711 may be connected to the sub word line driving signal PXID. The second NMOS transistor 713 is coupled between the output terminal of the inverting circuit and the ground terminal VSS. The gate of the second NMOS transistor 713 is connected to the inverting sub word line driving signal PXIB and responds to the inverting sub word line driving signal PXIB.

In an embodiment of the disclosure, a method for driving a circuit is also provided, which is applied to the circuit described in anyone of the above embodiments; the method includes controlling the semiconductor device to be in the off state when the standby state does not occur; and controlling the semiconductor device to be in the semi-conducting state when the standby state occurs, so as to increase the equivalent resistance of the semiconductor device and reduce the voltage output to the word line driving circuit.

What has been described above is only the preferred embodiment of this disclosure, and it is not intended to limit the scope of protection of this disclosure. Any modification, equivalent replacement and improvement within the principle of this disclosure should be included within the scope of protection of this disclosure.

### INDUSTRIAL APPLICATION

In the embodiments of the disclosure, by forming a semiconductor material layer with a width smaller than a width of the substrate along an extension direction of the gate, and according to the difference between the carrier mobility of the semiconductor material layer and the carrier mobility of the substrate, a control device with at least three states is provided, which at least includes three states of off, semi-conducting and full- conducting. **In** practical circuit application, it can switch various working states according to the voltage and reduce GIDL current.

## Claims

1. A semiconductor device, **characterized in that**, the semiconductor device comprises:
a substrate (10);
a semiconductor material layer (20) located on the substrate and covering a part of the substrate (10); and
a gate (30) directly located on the semiconductor material layer (20) and the substrate (10) not covered by the semiconductor material layer (20), wherein,
along an extension direction of the gate (30), a width of the semiconductor material layer (20) is smaller than a width of the substrate (10), and a carrier mobility of a material of the semiconductor material layer (20) is different from a carrier mobility of a material of the substrate (10), wherein,
the semiconductor device includes three states, and in the case that a voltage applied to the semiconductor device is less than a first threshold, the semiconductor device is in an off state; in the case that the voltage is greater than the first threshold and less than a second threshold, the semiconductor device is in a semi-conducting state; in the case that the voltage is greater than the second threshold, the semiconductor device is in a full-conducting state.

2. The semiconductor device according to claim 1, wherein,
the material of the substrate (10) comprises a first element, and the material of the semiconductor material layer (20) comprises the first element and a second element different from the first element.

3. The semiconductor device according to claim 2, wherein,
the first element is silicon and the second element is germanium.

4. The semiconductor device according to claim 2, wherein,
a percentage content of the second element in the semiconductor material layer (20) ranges from 20% to 40%.

5. The semiconductor device according to claim 1, further comprising:
a source (41) and a drain (42), which are respectively located on both sides of the gate (30) and penetrate through the semiconductor material layer (20) and extend into the substrate (10).

6. A method for manufacturing a semiconductor device, **characterized in that**, the method comprises:
providing a substrate (10);
forming a semiconductor material layer (20) on the substrate (10), wherein the semiconductor material layer (20) covers a part of the substrate (10); and
forming a gate (30) directly on the semiconductor material layer (20) and the substrate (10) not covered by the semiconductor material layer (20), wherein,
a width of the semiconductor material layer (20) is smaller than a width of the substrate (10) along an extension direction of the gate (30), and a carrier mobility of a material of the semiconductor material layer (20) is different from a carrier mobility of a material of the substrate (10).

7. The method according to claim 6, wherein,
the material of the substrate (10) includes a first element, and the material of the semiconductor material layer (20) includes the first element and a second element different from the first element;
preferably, the first element is silicon and the second element is germanium.

8. The method according to claim 7, wherein,
a percentage content of the second element in the semiconductor material layer ranges from 20% to 40%.

9. The method according to claim 6, wherein,
a semiconductor material layer (20) is formed by an in-situ doping epitaxial process, in which growth rates of the semiconductor material layer (20) in a middle area and an edge area of the substrate (10) are adjusted by controlling a flow rate of a growth gas, so that the semiconductor material layer (20) covers part of the substrate (10).

10. The method according to claim 6, wherein,
a photoresist layer (60) is formed on a mask layer (50) covering the substrate (10);
the photoresist layer (60) is exposed and developed, to transfer a preset pattern of the semiconductor material layer (20) in a photomask to the photoresist layer (60);
a portion of the mask layer (50) corresponding to the preset pattern of the semiconductor material layer (20) is removed to expose part of the substrate (10); and
the semiconductor material layer (20) is formed on the exposed substrate (10).

11. The method according to claim 6, further comprising:
performing ion doping on the semiconductor material layer (20) on both sides of the gate (30) and the substrate (10) under the semiconductor material layer (20) to form a source (41) and a drain (42) penetrating through the semiconductor material layer (20) and extending into the substrate (10).

12. A circuit, **characterized in that**, the circuit comprises:
a main word line, a sub word line, a word line driving circuit (71) and a voltage control module (72), wherein the voltage control module (72) comprises the semiconductor device according to anyone of claims 1 to 5, wherein,
the semiconductor device comprises a source terminal, a drain terminal and a gate terminal; the source terminal is connected to a high-level signal, the drain terminal is connected to a main word line, and the gate terminal is connected to a standby signal;
the word line driving circuit (71) is connected between the main word line and the sub word line; and
the voltage control module (72) is configured to reduce a voltage output to the word line driving circuit (71) in the case that a standby state occurs.

13. The circuit according to claim 12, wherein,
the word line driving circuit (71) comprises a first PMOS transistor (711), a first NMOS transistor (712) and a second NMOS transistor (713); gates of the first PMOS transistor (711) and the first NMOS transistor (712) are connected and are connected to the main word line; a source of the first NMOS transistor (712) and a source of the second NMOS transistor (713) are connected and are grounded; a drain of the first PMOS transistor (711), the drain of the first NMOS transistor (712) and the drain of the second NMOS transistor (713) are connected and are connected to the sub word line.

14. A method for driving a circuit, **characterized in that**, the method for driving a circuit is used to the circuit according to claim 12 or claim 13, and the method comprises:
controlling the semiconductor device (721) to be in an off state in the case that the standby state does not occur; and
controlling the semiconductor device (721) to be in a semi-conducting state in the case that the standby state occurs to increase an equivalent resistance of the semiconductor device (721) and reduce a voltage output to the word line driving circuit (71).

## Patentansprüche

1. Halbleitervorrichtung, **dadurch gekennzeichnet, dass** die Halbleitervorrichtung Folgendes umfasst:
ein Substrat (10);
eine Halbleitermaterialschicht (20), die sich auf dem Substrat befindet und einen Teil des Substrats (10) bedeckt; und
ein Gate (30), das sich direkt auf der Halbleitermaterialschicht (20) befindet, und das Substrat (10), das nicht von der Halbleitermaterialschicht (20) bedeckt ist, wobei
entlang der Erstreckungsrichtung des Gates (30) eine Breite der Halbleitermaterialschicht (20) kleiner ist als eine Breite des Substrats (10), und eine Trägermobilität eines Materials der Halbleitermaterialschicht (20) sich von einer Trägermobilität eines Materials des Materials des Substrats (10) unterscheidet, wobei
die Halbleitervorrichtung drei Zustände beinhaltet, und in dem Fall, dass eine an die Halbleitervorrichtung angelegte Spannung kleiner ist als ein erster Schwellenwert, die Halbleitervorrichtung in einem Aus-Zustand ist; in dem Fall, dass die Spannung größer ist als der erste Schwellenwert und kleiner ist als ein zweiter Schwellenwert, die Halbleitervorrichtung in einem halbleitenden Zustand ist; in dem Fall, dass die Spannung größer ist als der zweite Schwellenwert, die Halbleitervorrichtung in einem voll leitenden Zustand ist.

2. Halbleitervorrichtung nach Anspruch 1, wobei
das Material des Substrats (10) ein erstes Element umfasst, und das Material der Halbleitermaterialschicht (20) das erste Element und ein zweites Element, das sich von dem ersten Element unterscheidet, umfasst.

3. Halbleitervorrichtung nach Anspruch 2, wobei
das erste Element Silizium ist und das zweite Element Germanium ist.

4. Halbleitervorrichtung nach Anspruch 2, wobei
der Anteil des zweiten Elements in der Halbleitermaterialschicht (20) in einem Bereich von 20 % bis 40 % ist.

5. Halbleitervorrichtung nach Anspruch 1, ferner umfassend:
eine Source (41) und einen Drain (42), die sich jeweils auf beiden Seiten des Gates (30) befinden und die Halbleiterschicht (20) durchdringen und sich bis in das Substrat (10) erstrecken.

6. Verfahren zum Herstellen einer Halbleitervorrichtung, **dadurch gekennzeichnet, dass** das Verfahren Folgendes umfasst:
Bereitstellen eines Substrats (10);
Bilden einer Halbleitermaterialschicht (20) auf dem Substrat (10), wobei die Halbleitermaterialschicht (20) einen Teil des Substrats (10) bedeckt; und
Bilden eines Gates (30) direkt auf der Halbleitermaterialschicht (20) und dem Substrat (10), das nicht von der Halbleitermaterialschicht (20) bedeckt ist, wobei
eine Breite der Halbleitermaterialschicht (20) entlang einer Erstreckungsrichtung des Gates (30) kleiner ist als die Breite des Substrats (10), und eine Trägermobilität des Materials der Halbleitermaterialschicht (20) sich von einer Trägermobilität eines Materials des Substrats (10) unterscheidet.

7. Verfahren nach Anspruch 6, wobei
das Material des Substrats (10) ein erstes Element beinhaltet, und das Material der Halbleitermaterialschicht (20) das erste Element und ein zweites, von dem ersten verschiedenes Element beinhaltet;
vorzugsweise das erste Element Silizium ist und das zweite Element Germanium ist.

8. Verfahren nach Anspruch 7, wobei
ein prozentualer Anteil des zweiten Elements in der Halbleitermaterialschicht in einem Bereich von 20 % bis 40 % ist.

9. Verfahren nach Anspruch 6, wobei
eine Halbleitermaterialschicht (20) durch einen in-situ-Dotierungsepitaxieprozess gebildet wird, bei dem Wachstumsraten der Schicht (20) in einem mittleren Bereich und einem Randbereich des Substrats (10) durch Steuern der Flussrate eines Wachstumsgases eingestellt werden, sodass die Halbleitermaterialschicht (20) einen Teil des Substrats (10) bedeckt.

10. Verfahren nach Anspruch 6, wobei
auf einer Maskenschicht (50), die das Substrat (10) bedeckt, eine Photoresistschicht (60) gebildet wird;
die Photoresistschicht (60) belichtet und entwickelt wird, um ein voreingestelltes Muster der Halbleitermaterialschicht (20) in eine Photomaske der Photoresistschicht (60) zu übertragen;
ein Abschnitt der Maskenschicht (50), der dem voreingestellten Muster der Halbleitermaterialschicht (20) entspricht, entfernt wird, um einen Teil des Substrats (10) freizulegen; und
die Halbleitermaterialschicht (20) auf dem freiliegenden Substrat (10) gebildet wird.

11. Verfahren nach Anspruch 6, ferner umfassend:
Durchführen einer Ionendotierung auf der Halbleitermaterialschicht (20) auf beiden Seiten des Gates (30) und auf dem Substrat (10) unter der Halbleitermaterialschicht (20), um eine Source (41) und einen Drain (42) zu bilden, die die Halbleitermaterialschicht (20) durchdringen und sich in das Substrat (10) erstrecken.

12. Schaltung, **dadurch gekennzeichnet, dass** die Schaltung Folgendes umfasst:
eine Hauptwortleitung, eine Nebenwortleitung, eine Wortleitungstreiberschaltung (71) und ein Spannungssteuermodul (72), wobei das Spannungssteuermodul (72) die Halbleitervorrichtung nach einem der Ansprüche 1 bis 5 umfasst, wobei
die Halbleitervorrichtung einen Source-Anschluss, einen Drain-Anschluss und einen Gate-Anschluss umfasst; der Source-Anschluss mit einem High-Pegel-Signal verbunden ist, der Drain-Anschluss mit einer Hauptwortleitung verbunden ist und der Gate-Anschluss mit einem Standby-Signal verbunden ist;
die Wortleitungstreiberschaltung (71) zwischen Haupt- und Nebenwortleitung verbunden ist; und
das Spannungssteuermodul (72) konfiguriert ist, um eine Ausgangsspannung für die Wortleitungstreiberschaltung (71) zu reduzieren, wenn ein Standby-Zustand eintritt.

13. Schaltung nach Anspruch 12, wobei
die Wortleitungstreiberschaltung (71) einen ersten PMOS-Transistor (711), einen ersten NMOS-Transistor (712) und einen zweiten NMOS-Transistor (713) umfasst; die Gates des ersten PMOS-Transistors (711) und des ersten NMOS-Transistors (712) miteinander verbunden sind und mit der Hauptwortleitung verbunden sind; eine Source des ersten NMOS-Transistors (712) und des zweiten NMOS-Transistors (713) miteinander verbunden und geerdet sind; die Drain-Anschlüsse des ersten PMOS-Transistors (711), des ersten NMOS-Transistors (712) und des zweiten NMOS-Transistors (713) miteinander verbunden sind und mit der Nebenwortleitung verbunden sind.

14. Verfahren zum Ansteuern einer Schaltung, **dadurch gekennzeichnet, dass** das Verfahren zum Ansteuern einer Schaltung auf die Schaltung in Anspruch 12 oder 13 angewendet wird und das Verfahren Folgendes umfasst:
Steuern der Halbleitervorrichtung (721), um in einem ausgeschalteten Zustand zu sein, wenn der Standby-Zustand nicht auftritt; und
Steuern der Halbleitervorrichtung (721), um im Falle des Auftretens des Standby-Zustands in einem halbleitenden Zustand zu sein, um den äquivalenten Widerstand der Halbleitervorrichtung (721) zu erhöhen und die Ausgangsspannung an die Wortleitungstreiberschaltung (71) zu reduzieren.

## Revendications

1. Dispositif à semi-conducteur, **caractérisé en ce que** le dispositif à semi-conducteur comprend :
un substrat (10) ;
une couche de matériau semi-conducteur (20) située sur le substrat et recouvrant une partie du substrat (10) ; et
une grille (30) située directement sur la couche de matériau semi-conducteur (20) et le substrat (10) non recouvert par la couche de matériau semi-conducteur (20), dans lequel,
le long d'une direction d'extension de la grille (30), une largeur de la couche de matériau semi-conducteur (20) est inférieure à une largeur du substrat (10), et une mobilité des porteurs d'un matériau de la couche de matériau semi-conducteur (20) est différente d'une mobilité des porteurs d'un matériau du substrat (10), dans lequel,
le dispositif à semi-conducteur comprend trois états, et dans le cas où une tension appliquée au dispositif à semi-conducteur est inférieure à un premier seuil, le dispositif à semi-conducteur est dans un état éteint ; dans le cas où la tension est supérieure au premier seuil et inférieure à un second seuil, le dispositif à semi-conducteur est dans un état semi-conducteur ; dans le cas où la tension est supérieure au second seuil, le dispositif à semi-conducteur est dans un état de pleine conduction.

2. Dispositif à semi-conducteur selon la revendication 1, dans lequel,
le matériau du substrat (10) comprend un premier élément, et le matériau de la couche de matériau semi-conducteur (20) comprend le premier élément et un second élément différent du premier élément.

3. Dispositif à semi-conducteur selon la revendication 2, dans lequel,
le premier élément est le silicium et le second élément est le germanium.

4. Dispositif à semi-conducteur selon la revendication 2, dans lequel,
une teneur en pourcentage du second élément dans la couche de matériau semi-conducteur (20) est comprise entre 20 % et 40 %.

5. Dispositif à semi-conducteur selon la revendication 1, comprenant en outre :
une source (41) et un drain (42), qui sont situés respectivement de part et d'autre de la grille (30), qui traversent la couche de matériau semi-conducteur (20) et s'étendent dans le substrat (10).

6. Procédé de fabrication d'un dispositif à semi-conducteur, **caractérisé en ce que** le procédé comprend :
la fourniture d'un substrat (10) ;
la formation d'une couche de matériau semi-conducteur (20) sur le substrat (10), dans lequel la couche de matériau semi-conducteur (20) recouvre une partie du substrat (10) ; et
la formation d'une grille (30) directement sur la couche de matériau semi-conducteur (20) et le substrat (10) non recouvert par la couche de matériau semi-conducteur (20), dans lequel,
une largeur de la couche de matériau semi-conducteur (20) est inférieure à une largeur du substrat (10) le long d'une direction d'extension de la grille (30), et une mobilité des porteurs d'un matériau de la couche de matériau semi-conducteur (20) est différente d'une mobilité des porteurs d'un matériau du substrat (10).

7. Procédé selon la revendication 6, dans lequel,
le matériau du substrat (10) comprend un premier élément, et le matériau de la couche de matériau semi-conducteur (20) comprend le premier élément et un second élément différent du premier élément ;
de préférence, le premier élément est le silicium et le second élément est le germanium.

8. Procédé selon la revendication 7, dans lequel,
une teneur en pourcentage du second élément dans la couche de matériau semi-conducteur est comprise entre 20 % et 40 %.

9. Procédé selon la revendication 6, dans lequel,
une couche de matériau semi-conducteur (20) est formée par un processus épitaxial de dopage in situ, dans lequel les taux de croissance de la couche de matériau semi-conducteur (20) dans une zone centrale et une zone de bord du substrat (10) sont ajustés en contrôlant un débit d'un gaz de croissance, de sorte que la couche de matériau semi-conducteur (20) recouvre une partie du substrat (10).

10. Procédé selon la revendication 6, dans lequel,
une couche de résine photosensible (60) est formée sur une couche de masque (50) recouvrant le substrat (10) ;
la couche de résine photosensible (60) est exposée et développée afin de transférer un motif prédéfini de la couche de matériau semi-conducteur (20) figurant dans un masque photographique sur la couche de résine photosensible (60) ;
une partie de la couche de masque (50) correspondant au motif prédéfini de la couche de matériau semi-conducteur (20) est enlevée pour exposer une partie du substrat (10) ; et
la couche de matériau semi-conducteur (20) est formée sur le substrat exposé (10).

11. Procédé selon la revendication 6, comprenant en outre :
la réalisation d'un dopage ionique sur la couche de matériau semi-conducteur (20) des deux côtés de la grille (30) et du substrat (10) sous la couche de matériau semi-conducteur (20) pour former une source (41) et un drain (42) pénétrant à travers la couche de matériau semi-conducteur (20) et s'étendant dans le substrat (10).

12. Circuit, **caractérisé en ce que** le circuit comprend :
une ligne de mots principale, une sous-ligne de mots, un circuit de commande de ligne de mots (71) et un module de commande de tension (72), dans lequel le module de commande de tension (72) comprend le dispositif à semi-conducteur selon l'une quelconque des revendications 1 à 5, dans lequel,
le dispositif à semi-conducteur comprend une borne de source, une borne de drain et une borne de grille ; la borne de source est connectée à un signal de niveau élevé, la borne de drain est connectée à une ligne de mots principale, et la borne de grille est connectée à un signal de veille ;
le circuit de commande de ligne de mots (71) est connecté entre la ligne de mots principale et la sous-ligne de mots ; et
le module de commande de tension (72) est configuré pour réduire une tension de sortie destinée au circuit de commande de ligne de mots (71) dans le cas où un état de veille se produit.

13. Circuit selon la revendication 12, dans lequel,
le circuit de commande de ligne de mots (71) comprend un premier transistor PMOS (711), un premier transistor NMOS (712) et un second transistor NMOS (713) ; les grilles du premier transistor PMOS (711) et du premier transistor NMOS (712) sont connectées et sont reliées à la ligne de mots principale ; une source du premier transistor NMOS (712) et une source du second transistor NMOS (713) sont connectées et sont mises à la terre ; un drain du premier transistor PMOS (711), le drain du premier transistor NMOS (712) et le drain du second transistor NMOS (713) sont connectés et sont connectés à la sous-ligne de mots.

14. Procédé de commande d'un circuit, **caractérisé en ce que** le procédé de commande d'un circuit est utilisé pour le circuit selon la revendication 12 ou la revendication 13, et le procédé comprend :
la commande du dispositif semi-conducteur (721) pour qu'il soit dans un état éteint dans le cas où l'état de veille ne se produit pas ; et
la commande du dispositif à semi-conducteur (721) pour qu'il soit dans un état semi-conducteur en cas d'état de veille afin d'augmenter une résistance équivalente du dispositif à semi-conducteur (721) réduire une tension de sortie vers le circuit de commande de ligne de mots (71).
